# EUROPEAN PATENT APPLICATION

(11) **EP 2 736 082 A2**
(43) Date of publication of application: **28.05.2014**
(21) Application number: 13186753.3
(22) Date of filing: 30.09.2013
(51) Int. Cl.: H01L 31/02, H01L 31/042

(54) **Photoelectric module**

(30) Priority: 26.11.2012 KR 20120134865
(71) Applicant: Samsung SDI Co., Ltd., Yongin-si, Gyeonggi-do (KR)
(72) Inventor: Kim, Hyun-Chul, Gyeonggi-do (KR)
(74) Representative: Walaski, Jan Filip

(57) **Abstract**

A photoelectric module includes a substrate, first and second rear electrodes on the substrate and separated from each other by a first separation pattern, first and second light absorbing layers on the first and second rear electrodes and separated from each other by a second separation pattern, and first and second front electrodes on the light absorbing layer and separated from each other by a third separation pattern. One of the first and second rear electrodes has a rear connecting portion and an opposite one of the first and second front electrodes has a front connecting portion. The first separation pattern is in a bent shape to enclose the rear connecting portion and the third separation pattern is in a bent shape to enclose the front connecting portion. The rear connecting portion and the front connecting portion are disposed facing each other along a z-axis and are electrically connected.

## Description

The present invention relates to a photoelectric module.

Due to draining energy resources and increasing global environmental problems, development of clean energies has been accelerating. Since solar cells directly convert sunlight into electrical energy, solar cells are expected to be a new energy resource.

However, the cost of generating electricity even using industrially produced solar cells is still high compared with other methods, e.g., thermal power generation. Thus, enhancing the generation efficiency of solar cells is needed in order to apply solar cells to various applications.

According to an aspect of the invention, there is provided a photoelectric module comprising first and second photoelectric cells wherein each of the first and second photoelectric cells comprises a rear electrode, a light absorbing layer on the rear electrode and a front electrode on the light absorbing layer and the rear electrode of the first photoelectric cell has a protruding portion that forms a rear electrode connecting portion and the rear electrode of the second photoelectric cell has a recessed portion arranged to receive the protruding portion and the front electrode of the second photoelectric cell has a protruding portion that forms a front electrode connecting portion and the front electrode of the first photoelectric cell has a recessed portion arranged to receive the protruding portion, wherein the rear and front electrode connecting portions are aligned to face one another and electrically connected to each other.

One or more embodiments provide a photoelectric module including a substrate, first and second rear electrodes on the substrate, the first and second rear electrodes being separated by a first separation pattern, first and second light absorbing layers on the first and second rear electrodes, the first and second light absorbing layers being separated by a second separation pattern, and first and second front electrodes on the light absorbing layer, first and second front electrodes being separated by a third separation pattern, wherein one of the first and second rear electrodes has a rear connecting portion, an opposite one of the first and second front electrodes has a front connecting portion, the first separation pattern is in a bent shape to enclose the rear connecting portion, the third separation pattern is in a bent shape to enclose the front connecting portion, and the rear connecting portion and the front connecting portion are disposed facing each other along a z-axis and are electrically connected to each other.

The first photoelectric cell may include the first rear electrode, the first front electrode, and the light absorbing layer, and the second photoelectric cell may include the second rear electrode, the second front electrode, and the light absorbing layer.

The rear connecting portion may form an end portion of the first rear electrode that protrudes toward the second rear electrode.

The rear connecting portion may be formed as a portion of the first rear electrode and integral with the first rear electrode.

The front connecting portion may form an end portion of the second front electrode that protrudes toward the first front electrode.

The front connecting portion may be formed as a portion of the second front electrode and integral with the second front electrode.

The rear connecting portion may protrude toward the second photoelectric cell from the first photoelectric cell, the front connecting portion may protrude toward the first photoelectric cell from the second photoelectric cell, and the first separation pattern and the second separation pattern may be bent in an opposite direction to each other so as to enclose the rear connecting portion and the front connecting portion protruded in an opposite direction to each other.

A connecting pattern of the light absorbing layer may be interposed between the rear connecting portion and the front connecting portion.

The connecting pattern may form an end portion of the light absorbing layer belonging to the second photoelectric cell, the end portion being protruded toward the light absorbing layer of the first photoelectric cell.

The second separation pattern may be formed bent so as to enclose the connecting pattern.

The rear connecting portion may be protruded toward the second photoelectric cell from the first photoelectric cell, the front connecting portion may be protruded toward the first photoelectric cell from the second photoelectric cell, the connecting pattern may be protruded toward the first photoelectric cell from the second photoelectric cell, the first separation pattern and the second separation pattern may be bent in an opposite direction to each other so as to enclose the rear connecting portion and the front connecting portion protruded in an opposite direction to each other, and the second separation pattern and the third separation pattern may be bent in the same direction as each other so as to enclose the connecting pattern and the front connecting portion protruded in the same direction as each other.

The first separation pattern and the third separation pattern may be formed in a bent shape together with a line pattern extending in a different direction.

The first separation pattern and the third separation pattern may be formed in a bent shape including a rounded pattern.

The first separation pattern and the third separation pattern may have a shape bent along angular corners.

The first separation pattern and the third separation pattern may have a shape bent along rounded corners.

The light absorbing layer may include a chalcopyrite semiconductor.

The light absorbing layer may include a copper-indium-gallium-selenide (CIGS)-based compound.

The second and third separation portions may completely overlap.

The rear connecting portion and the front connecting portion may completely overlap.

The rear connecting portion and the front connecting portion may be electrically connected by the light absorbing layer.

Features will become apparent to those of ordinary skill in the art by describing in detail exemplary embodiments with reference to the attached drawings in which:
FIG. 1 illustrates a perspective view of a photoelectric module according to an embodiment;
FIG. 2 illustrates an exploded perspective view of the photoelectric module illustrated in FIG. 1;
FIG. 3 illustrates a cross-sectional view taken along a line III-III of FIG. 2;
FIGS. 4 through 6 are views illustrating planar structures of a rear electrode, a light absorbing layer and a front electrode, according to an embodiment;
FIG. 7 illustrates a first separation pattern according to an embodiment;
FIG. 8 illustrates a second separation pattern and a third separation pattern, according to an embodiment of the present invention;
FIG. 9 illustrates a first separation pattern, a second separation pattern and a third separation pattern together, according to an embodiment of the present invention;
FIG. 10 illustrates a cross-sectional view of a photoelectric module according to a comparative example to be contrasted with the present invention; and
FIG. 11 illustrates a schematic view of a separation pattern of a photoelectric module according to the comparative example of FIG. 10.

Hereinafter, a photoelectric device according to embodiments will be described with reference to the accompanying drawings.

Referring to the drawings, the photoelectric module may include a plurality of, e.g., two, photoelectric cells C1 and C2. While two photoelectric cells C1 and C2 are illustrated in the drawings for convenience of understanding, embodiments are not limited thereto. The technical principles to be described below will be equally applicable to photoelectric modules having more than two electrically connected photoelectric cells.

Referring to the drawings, the photoelectric module includes a substrate 100, a rear electrode 110, a light absorbing layer 150, and a front electrode 120. In an embodiment, the substrate 100 may be shared by the first and second photoelectric cells C1 and C2, and the rear electrode 110, the light absorbing layer 150, and the front electrode 120 may be each divided with respect to the respective first and second photoelectric cells C1 and C2. As will be described later, the rear electrode 110, the light absorbing layer 150, and the front electrode 120 may be respectively divided by a first separation pattern P1, a second separation pattern P2, and a third separation pattern P3 with respect to the first and second photoelectric cells C1 and C2.

For example, the rear electrode 110 may include a first rear electrode 111 of the first photoelectric cell C1 and a second rear electrode 112 of the second photoelectric cell C2. The light absorbing layer 150 may include a first light absorbing layer 151 of the first photoelectric cell C1 and a second light absorbing layer 152 of the second photoelectric cell C2. The front electrode 120 may include a first front electrode 121 of the first photoelectric cell C1 and a second front electrode 122 of the second photoelectric cell C2. A description of this will be given in more detail below.

The substrate 100 may be a glass substrate, e.g., a sodalime glass substrate. Alternatively, the substrate 100 may include, e.g., a ceramic substrate containing alumina, a metal substrate containing stainless steel or titanium, and a polymer substrate containing polyimide.

The rear electrode 110 may be formed of an electrical conductor. For example, the rear electrode 110 may be formed of a molybdenum (Mo) thin film by sputtering using molybdenum as a target material. Using molybdenum for the rear electrode 110 provides a high electrical conductivity, ability to form an ohmic contact with the light absorbing layer 150, and high temperature stability in a selenium (Se) atmosphere, i.e., under conditions that may be used to form the light absorbing layer 150. When the rear electrode 110 has a low specific resistance and good adherence to the substrate 100, delamination due to a difference in thermal expansion coefficients may be reduced or prevented.

Alternatively, the rear electrode 110 may be formed of a metal material in addition to Mo, such as titanium (Ti), tungsten (W), or the like, or may be formed of a metal oxide, e.g., indium tin oxide (ITO), tin oxide (SnO₂), zinc oxide (ZnO), or the like. Further, the rear electrode 110 may be formed in one or more layers. For example, the rear electrode 110 may include layers of different materials.

The rear electrodes 111 and 112 of the neighboring first and second photoelectric cells C1 and C2 are separated from each other by the first separation pattern P1, and may be insulated from each other. For example, the first separation pattern P1 may be formed by laser scribing or mechanical scribing. Thus, the rear electrode 110 formed on the substrate 100 may be separated into the first and second rear electrodes 111 and 112 corresponding to the respective first and second photoelectric cells C1 and C2 by the first separation pattern P1.

The light absorbing layer 150 may generate a photoelectromotive force according to the photoelectric effect in response to light incident thereon. The light absorbing layer 150 may include a chalcopyrite semiconductor. More specifically, the light absorbing layer 150 may include a copper-indium-gallium-selenide (CIGS)-based compound (Cu(In,Ga)Se₂).

Alternatively, the light absorbing layer 150 may include a copper-indium-selenide (CIS)-based compound (CuInSe₂) or a copper-gallium-selenide (CGS)-based compound (CuGaSe₂). The light absorbing layer 150 may be formed by an evaporation process or a selenization process. For example, in the evaporation process, copper (Cu), indium (In), and gallium (Ga), or Cu, In, Ga, and selenium (Se) may be deposited on the rear electrode 110 to form the light absorbing layer 150. For example, in the selenization process, the light absorbing layer 150 may be formed by first forming a precursor of a CuGa/In layer including a copper-gallium (Cu-Ga) alloy layer through sputtering and then performing selenization or sulfurization of the precursor.

The light absorbing layers 151 and 152 of the neighboring first and second photoelectric cells C1 and C2 are separated from each other by the second separation pattern P2, and may be insulated from each other. The second separation pattern P2 may be formed by performing laser scribing or mechanical scribing, and thus, the light absorbing layer 150 formed on the substrate 100 may be separated into the first and second light absorbing layers 151 and 152 corresponding to the respective first and second photoelectric cells C1 and C2 by the second separation pattern P2.

Although not shown in the drawings, a buffer layer may be formed on the light absorbing layer 150. For example, the buffer layer may improve the interface between the light absorbing layer 150 and the front electrode 120. For example, when the p-type light absorbing layer 150 and the n-type front electrode 120 form a p-n junction, since the p-type light absorbing layer 150 and the n-type front electrode 120 have a large difference in terms of an energy band gap, a buffer layer having an intermediate energy band gap may be interposed between the p-type light absorbing layer 150 and the n-type front electrode 120. For example, the buffer layer may be a thin layer of CdS, ZnS, or InS. The buffer layer may be separated together with the light absorbing layer 150 by the second separation pattern P2, and the separated buffer layers of the first and second photoelectric cells C1 and C2 may be electrically insulated from each other by the second separation pattern P2.

The front electrode 120 may be formed on the light absorbing layer 150. The front electrode 120 may form a p-n junction with the light absorbing layer 150, be disposed on a front surface of the photoelectric module, and function as an electrode. The front electrode 120 may be formed of a transparent conductive material having a high transmittance and a high electrical conductivity. For example, the front electrode 120 may include a metal oxide, such as indium tin oxide (ITO), tin oxide (SnO₂), zinc oxide (ZnO), or the like. Also, the front electrode 120 may include a mixture of the above-mentioned metal oxide and one or more impurities. For example, the front electrode 120 may be formed of zinc oxide doped, e.g., with boron (B), aluminum (Al), gallium (Ga), or the like, in order to increase the electrical conductivity thereof.

The front electrode 120 of the neighboring first and second photoelectric cells C1 and C2 is divided by the third separation pattern P3, and the resulting first and second front electrodes 121, 122 may be electrically insulated from each other. The third separation pattern P3 may be formed by laser scribing or mechanical scribing. Thus, the front electrode 120 formed on the substrate 100 may be separated by the third separation pattern P3 into the first and second front electrodes 121 and 122 corresponding to the respective first and second photoelectric cells C1 and C2.

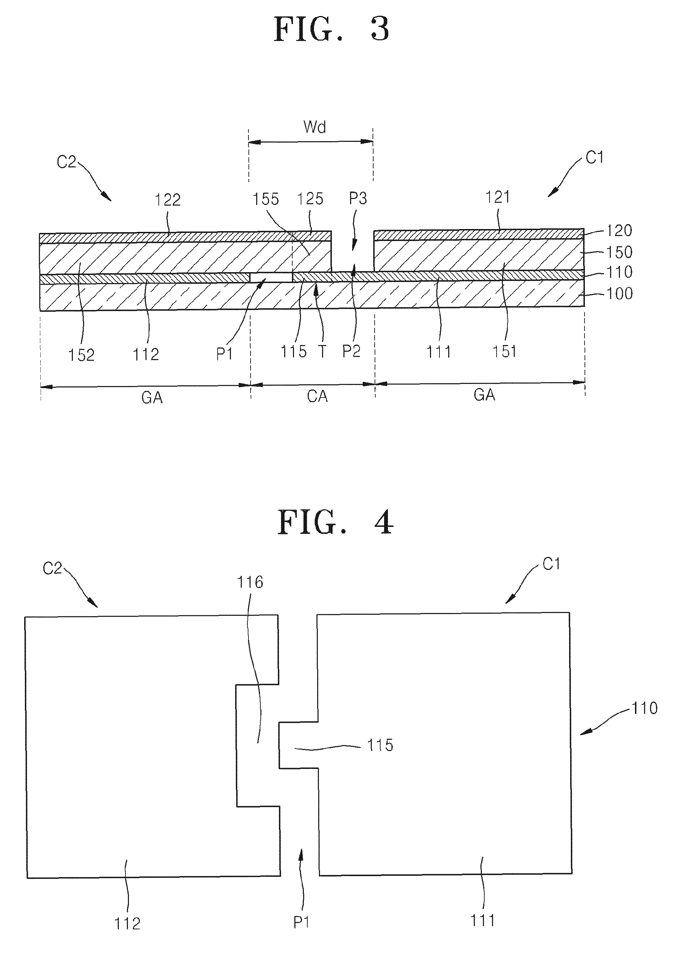

Referring to FIG. 3, the photoelectric module includes an effective generation area GA for converting input incident light into an electrical output. For example, the effective generation area GA may correspond to an area occupied by the photoelectric cells C1 and C2 excluding the area occupied by the separation patterns P1, P2, and P3, i.e., a connecting area CA. The connecting area CA electrically separates the neighboring first and second photoelectric cells C1 and C2, and, at the same time, connects the separated first and second photoelectric cells C1 and C2 in series or in parallel.

Since the light absorbing layer 150 is formed in the connecting area CA, the photoelectric module may generate an electrical output from incident light in the connecting area CA. However, since the conversion efficiency of the connecting area CA is much lower than that of the effective generation area GA, an overall output of the photoelectric module depends primarily on the output of the effective generation area GA, which is proportional to an area thereof.

The first separation pattern P1 may divide the rear electrode 110 into the first and second rear electrodes 111 and 112 of the neighboring first and second photoelectric cells C1 and C2 to insulate the second rear electrodes 111 and 112 from each other. The second separation pattern P2 may divide the light absorbing layer 150 into the first and second light absorbing layers 151 and 152 of the neighboring first and second photoelectric cells C1 and C2 to insulate the first and second light absorbing layers 151 and 152 from each other. The third separation pattern P3 may divide the front electrode 120 into the first and second front electrodes 121 and 122 of the neighboring first and second photoelectric cells C1 and C2 to insulate the first and second front electrodes 121 and 122 from each other.

The neighboring first and second photoelectric cells C1 and C2 may be connected in series or in parallel to form a module. For example, the neighboring first and second photoelectric cells C1 and C2 may be connected in series or in parallel corresponding to a required output voltage or output current. In the embodiment illustrated in FIG. 3, the rear electrode 110 and the front electrode 120 of the neighboring first and second photoelectric cells C1 and C2 are connected to form a serial connection. More specifically, the first rear electrode 111 of the first photoelectric cell C1 and the front electrode 122 of the second photoelectric cell C2 are electrically connected to each other. Thus, the first and second photoelectric cells C1 and C2 are connected in series.

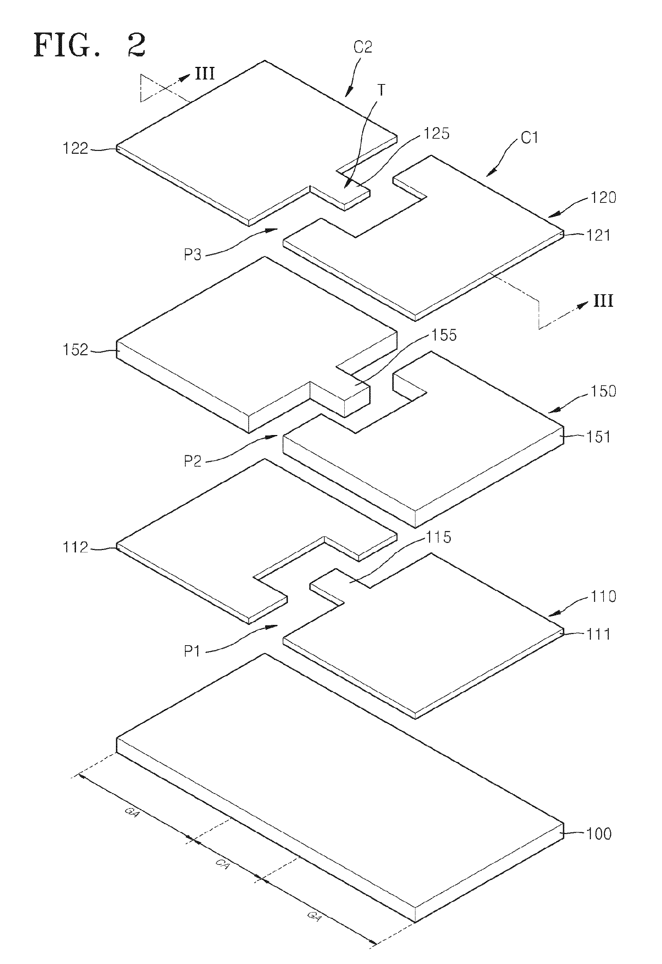

Referring to FIG. 2, the rear electrode 111 of the first photoelectric cell C1 may be connected to the front electrode 122 of the neighboring second photoelectric cell C2, and the rear electrode 111 and the front electrode 122 may be electrically connected to each other through a connecting area T. As the rear electrode 111 and the front electrode 122 are thus connected to each other, the neighboring different first and second photoelectric cells C1 and C2 are connected in series.

For example, the first rear electrode 111 and the second front electrode 122 of the neighboring photoelectric cells C1 and C2 may be electrically connected to each other through connecting portions that protrude to a position facing each other in a stack direction. In particular, the rear electrode 111 of the first photoelectric cell C1 may include a rear connecting portion, also referred to as a rear electrode connecting portion, 115 that protrudes toward the neighboring second photoelectric cell C2. The rear connecting portion 115 forms an end portion of the first rear electrode 111, and may be integral with the remaining portion of the first rear electrode 111. The front electrode 122 of the second photoelectric cell C2 may include a front connecting portion, also referred to as a front electrode connecting portion, 125 that protrudes toward the neighboring first photoelectric cell C1. The front connecting portion 125 forms an end portion of the second front electrode 122, and may be integral with the remaining portion of the second front electrode 122.

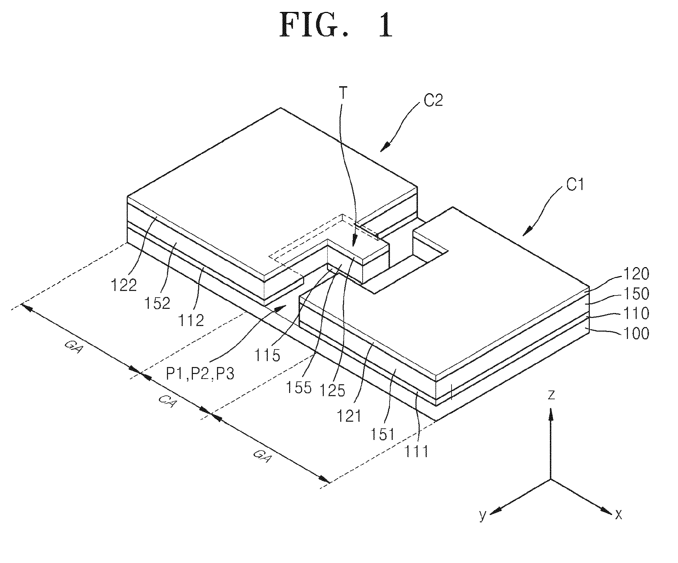

As can be seen in FIGS. 1-3, the rear and front connecting portions 115 and 125 are formed at positions facing each other along the z-axis and may overlap, e.g., completely overlap along the x and y axes. The rear and front connecting portions 115 and 125 may be electrically connected to each other through a connecting pattern 155 of the light absorbing layer 150 interposed therebetween. The connecting pattern 155 of the light absorbing layer 150 may overlap, e.g., completely overlap, the rear connecting portion 115 and the front connecting portion 125, thus facilitating electrical connection of the rear and front connecting portions 115 and 125. As the rear electrode 111 and the front electrode 122 are thus electrically connected to each other, the first and second photoelectric cells C1 and C2 are connected in series.

The rear connecting portion 115 may be defined by the first separation pattern P1 separating the rear electrodes 111 and 112 of the neighboring first and second photoelectric cells C1 and C2. The front connecting portion 125 may be defined by the third separation pattern P3 separating the front electrodes 121 and 122 of the neighboring first and second photoelectric cells C1 and C2. The connecting pattern 155 of the light absorbing layer 150 connecting the rear connecting portion 115 and the front connecting portion 125 may be defined by the second separation pattern P2 separating the light absorbing layer 150 of the neighboring photoelectric cells C1 and C2.

As illustrated in FIG. 3, the second and third separation patterns P2 and P3 may overlap, e.g., completely overlap, to thus decrease the area of the connecting area CA defined from the first separation pattern P1 to the third separation pattern P3. By decreasing the area of the connecting area CA for serial or parallel connection of the neighboring photoelectric cells C1 and C2, the area of the effective generation area GA may be relatively increased, providing an overall enhancement in output performance of the photoelectric module.

FIGS. 4 through 6 respectively illustrate planar structures of the rear electrode 110, the light absorbing layer 150, and the front electrode 120 illustrated in FIG. 3.

Referring to FIG. 4, the rear electrodes 111 and 112 of the first and second photoelectric cells C1 and C2 are separated and defined by the first separation pattern P1. For example, the first separation pattern P1 may be formed in a nonlinear or bent shape, e.g., a shape bent along angular corners or rounded corners (not shown). The first and second rear electrodes 111 and 112 may be formed with the first separation pattern P1 having the bent shape as a boundary therebetween. With the first separation pattern P1 serving as a boundary, the rear connecting portion 115 that protrudes toward the second rear electrode 112 may be formed in the first rear electrode 111. The second rear electrode 112 may have an indented shape complementary to the rear connecting portion 115. As illustrated in FIG. 4, since the first separation pattern P1 is bent so as to enclose some of the first rear electrode 111, the protruding rear connecting portion 115 may be formed in the first rear electrode 111 and the second rear electrode may have a complementary indented shape. In other words, the rear electrode connecting portion comprises a protrusion 115 in the first rear electrode 111 that is arranged to be received in a corresponding recess in the second rear electrode 112. The recess allows the first rear electrode 111 to be disposed closer to the second rear electrode 112 without the protrusion 115 touching the second rear electrode.

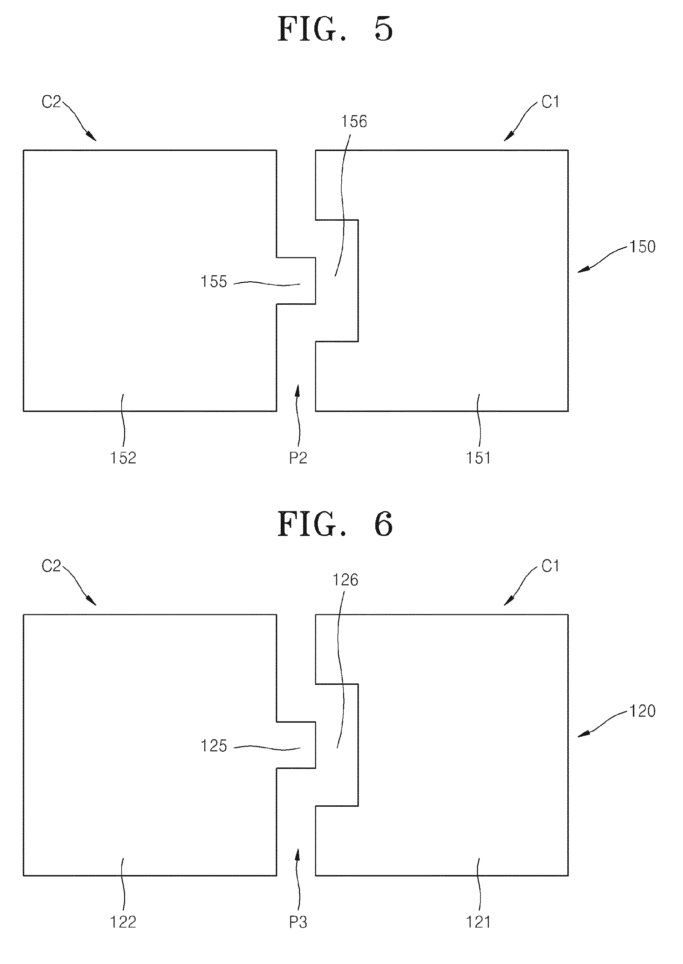

Referring to FIG. 5, the light absorbing layer 150 of the first and second photoelectric cells C1 and C2 are separated by the second separation pattern P2 and may be defined by the second separation pattern P2. For example, the second separation pattern P2 may be formed in nonlinear or bent shape, e.g., a shape bent along angular corners or rounded corners (not shown). The first and second light absorbing layers 151 and 152 may be formed with the second separation pattern P2 having the bent shape being a boundary therebetween. With the second separation pattern P2 serving as a boundary, the connecting pattern or portion 155 that protrudes toward the first light absorbing layer 151 may be formed. The first light absorbing layer 151 may have an indented shape complementary to the connecting pattern 155. In the embodiment illustrated in FIG. 5, since the second separation pattern P2 is bent so as to enclose some of the second light absorbing layer 152, the protruding connecting pattern 155 may be formed in the second light absorbing layer 152 and the first light absorbing layer 151 may have a complementary indented shape. In other words, the protruding connecting portion comprises a protrusion 155 in the second light absorbing layer 152 that is arranged to be received in a corresponding recess in the first light absorbing layer 151. The recess allows the second light absorbing layer 152 to be disposed closer to the first light absorbing layer 151 without the protrusion 155 touching the first light absorbing layer 151.

Referring to FIGS. 4 and 5, the first and second separation patterns P1 and P2 may have shapes bent in opposite directions to each other. For example, if the first separation pattern P1 is bent so as to enclose some of the first photoelectric cell C1, i.e., to enclose the rear connecting portion 115, the second separation pattern P2 may be bent so as to enclose some of the second photoelectric cell C2, i.e., to enclose the connecting pattern 155. Thus, the rear connecting portion 115 formed in the first photoelectric cell C1 and the connecting pattern 155 of the second photoelectric cell C2 may overlap, e.g., completely overlap, and be in contact, e.g., direct contact, such that the first and second photoelectric cells C1 and C2 are electrically connected.

Referring to FIG. 6, the front electrodes 121 and 122 of the first and second photoelectric cells C1 and C2 are separated by the third separation pattern P3 and may be defined by the third separation pattern P3. For example, the third separation pattern P3 may be formed in a nonlinear or bent shape, e.g., a shape bent along angular corners or rounded corners (not shown). The first and second front electrodes 121 and 122 may be formed with the third separation pattern P3 being a boundary. The first and second front electrodes 121 and 122 may be formed with the third separation pattern P3 having the bent shape being a boundary therebetween. With the third separation pattern serving as a boundary, the front connecting portion 125 that protrudes toward the first front electrode 121 may be formed in the second front electrode 122. The first front electrode 121 may have an indented shape complementary to the front connecting portion 125. In the embodiment illustrated in FIG. 6, since the third separation pattern P3 is bent so as to enclose some of the second front electrode 122, the protruding front connecting portion 125 may be formed in the second front electrode 122 and the first front electrode 121 may have a complementary indented shape. In other words, the front electrode connecting portion comprises a protrusion 125 in the second front electrode 122 that is arranged to be received in a corresponding recess in the first front electrode 121. The recess allows the first front electrode 121 to be disposed closer to the second front electrode 122 without the protrusion 125 touching the first front electrode.

Referring to FIGS. 5 and 6, the second and third separation patterns P2 and P3 may have shapes bent in the same direction as each other. For example, the second and third separation patterns P2 and P3 may be bent so as to enclose some of the second photoelectric cell C2. Thus, the connecting pattern 155 and the front connecting portion 125 each having the protruding shape may be formed in the second photoelectric cell C2, respectively.

Referring to FIGS. 4 and 6, the first and third separation patterns P1 and P3 may have shapes bent in different direction from each other. For example, if the first separation pattern P1 is bent so as to enclose some of the first photoelectric cell C1, i.e., to enclose the rear connecting portion 115, the third separation pattern P3 may be bent so as to some of the second photoelectric cell C2, i.e., to enclose the front connecting portion 125. Thus, the rear connecting portion 115 formed in the first photoelectric cell C1 and the front connecting portion 125 formed in the second photoelectric cell C2 are formed at a position facing each other along the z-axis and are electrically connected to each other, e.g., through the connecting pattern 155. Thus, the first and second photoelectric cells C1 and C2 may be electrically connected. Of course, alternatively, the first separation pattern P1 could enclose some of the second photoelectric cell C2 and the third separation pattern P3 could enclose some of the first photoelectric cell C1.

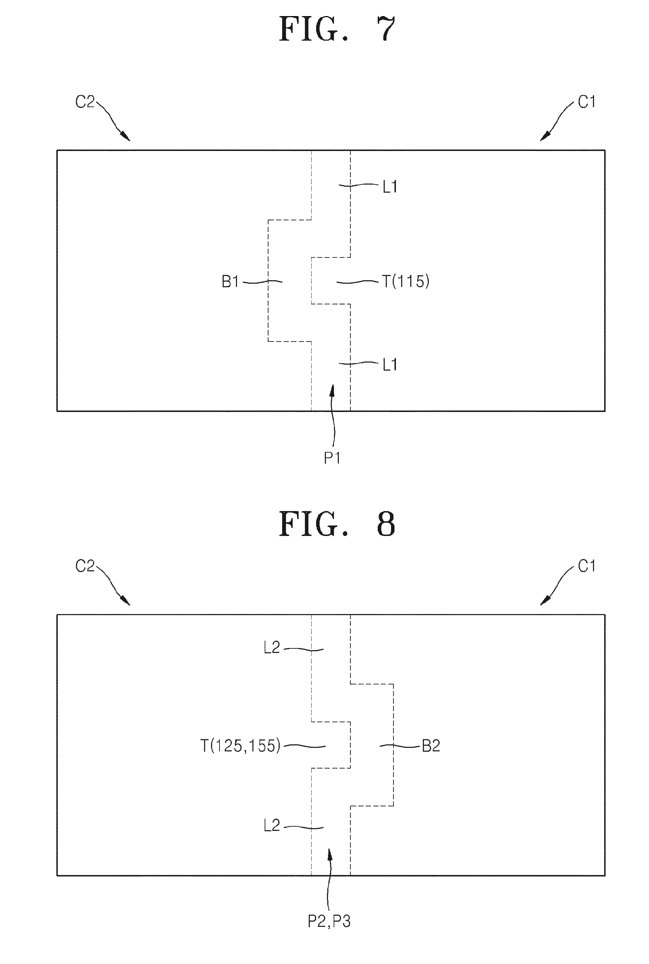

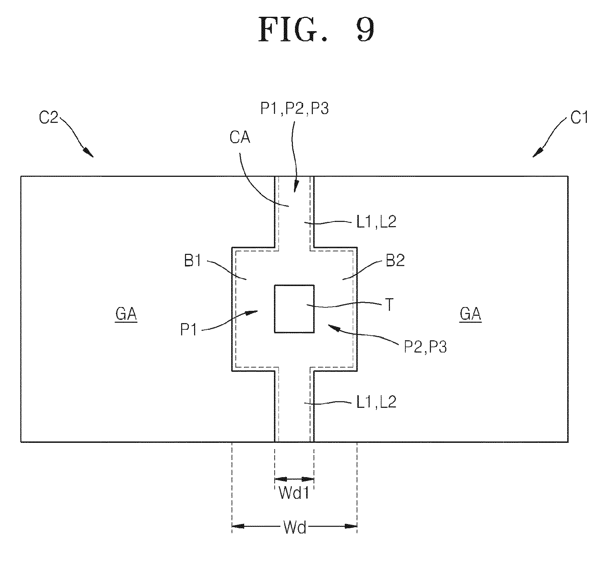

Separation patterns of a photoelectric module according to an embodiment are illustrated in FIGS. 7 to 9. FIG. 7 illustrates the shape of the first separation pattern P1, and FIG. 8 illustrates the second separation pattern P2 and the third separation pattern P3, respectively. FIG. 9 illustrates the first, second and third separation patterns overlapping one another.

Assuming that the first separation pattern P1 is formed in a bent shape so as to enclose some of the first photoelectric cell C1, i.e., to enclose the rear connecting portion 115, the second and third separation patterns P2 and P3 may be formed in a bent shape in an opposite direction to the first separation pattern P1 so as to enclose some of the second photoelectric cell C2.

The first separation pattern P1, the second separation pattern P2, and the third separation pattern P3 have bent shapes, and may be formed in bent shapes including a line pattern extending in different directions from one another. Alternatively, the first separation pattern P1, the second separation pattern P2, and the third separation pattern P3 may be formed in bent shapes each including a concavely rounded pattern.

More specifically, the first separation pattern P1 and the second and third separation patterns P2 and P3 may have patterns bent in opposite directions to each other, and the second and third separation patterns P2 and P3 may have patterns bent in the same direction as each other so as to overlap, e.g., completely overlap, each other. The neighboring first and second photoelectric cells C1 and C2 may be electrically connected to each other through the connecting portion T formed between the first separation pattern P1 and the second and third separation patterns P2 and P3. For example, the connecting portion T may include the rear connecting portion 115, the connecting pattern 155, and the front connecting portion 125.

The first separation pattern P1 and the second and third separation patterns P2 and P3 may have linear or stripe patterns L1 and L2 extending at a non-bent portion in one direction, and the stripe patterns L1 and L2 of the first to third separation patterns P1 to P3 may overlap, e.g., completely overlap, one another.

For example, the connecting area CA where the first separation pattern P1, the second separation pattern P2, and the third separation pattern P3 are formed becomes an area for separating the first and second photoelectric cells C1 and C2, and, at the same time, for connecting the separated first and second photoelectric cells C1 and C2 in series or in parallel. While the connecting area CA may generate electricity according to photoelectric conversion, the connecting area CA may have a low output performance compared with that of the effective generation area GA, which includes the complete photoelectric cells C1 and C2.

Considering the relative efficiencies noted above, the connecting area CA may be minimized relative to the overall area of the photoelectric module. According to an embodiment, a bent pattern B1 and a bent pattern B2 may be spaced apart from each other by the connecting portion T, and the second and third separation patterns P2 and P3 may be formed in substantially the same region, to thus decrease a width Wd of the connecting area CA.

Further, by forming the first to third separation patterns P1, P2 and P3 in bent shapes, the connecting portion T between the first separation pattern P1 and the second and third separation patterns P2 and P3 may be formed at an intermediate position, and the stripe patterns L1 and L2 where the connecting portion T is not formed may all be formed at the same position so as to overlap each other, to further decrease the width Wd1 of the connecting area CA.

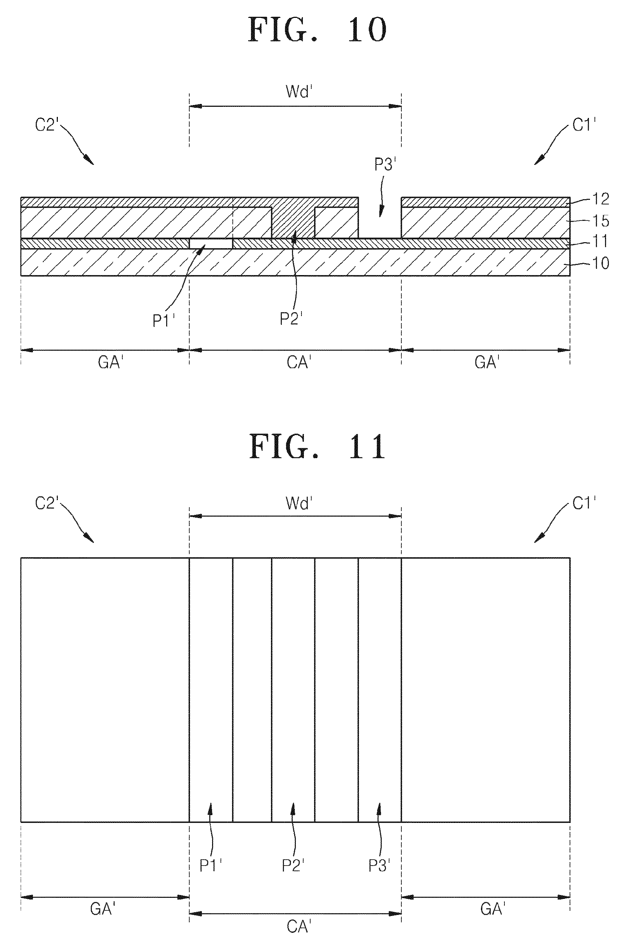

FIG. 10 is a cross-sectional view of a photoelectric module according to a comparative example to be contrasted with embodiments disclosed herein. Referring to FIG. 10, the photoelectric module includes first and second photoelectric cells C1' and C2' that are electrically connected to each other to form a module. The photoelectric module includes an effective generation area GA' for generating an electrical output from incident light, and a connecting area CA' for electrically connecting the neighboring photoelectric cells C1' and C2', which is formed between the effective generation areas GA'.

More specifically, the photoelectric module may include a substrate 10, a rear electrode 11, a light absorbing layer 15, and a front electrode 12 sequentially formed on the substrate 10. The substrate 10 may be shared by each of the photoelectric cells C1' and C2', and the rear electrode 11, the light absorbing layer 15, and the front electrode 12 may be each divided with respect to the photoelectric cells C1' and C2'. The rear electrode 11 may be separated in each of the photoelectric cells C1' and C2' by a first separation pattern P1'. The light absorbing layer 15 may be separated in each of the photoelectric cells C1' and C2' by a second separation pattern P2'. The front electrode 12 may be separated in each of the photoelectric cells C1' and C2' by a third separation pattern P3'. In the comparative example, the configuration assumes the front electrode 12 needs to be in contact with the rear electrode 11 to sufficiently couple the first and second photoelectric cells C1' and C2', i.e., that the front electrode 12 contacts the rear electrode 11 in the second separation pattern P2'.

The connecting area CA' from the first separation pattern P1' to the third separation pattern P3' electrically separates the first and second photoelectric cells C1' and C2', and forms an area for connecting the first and second photoelectric cells C1' and C2' in series. Since the rear electrode 11 and the front electrode 12 of the first and second photoelectric cells C1' and C2' are electrically connected to each other in the connecting area CA', the first and second photoelectric cells C1' and C2' may not separate and accumulate charge carriers. Thus, the connecting area CA' forms a dead-area which does not substantially contribute to electricity generation.

Since the first separation pattern P1', the second separation pattern P2', and the third separation pattern P3' are formed at different areas with a sufficient margin therebetween, in consideration of a process margin, the width Wd' of the connecting area CA' increases, increasing the dead area, so that an overall efficiency of the photoelectric module is reduced by as much as the increase in the dead area.

In contrast, according to embodiments herein, since the connecting area CA ranging from the first separation pattern P1 to the third separation pattern P3 may have a relatively small width Wd', a dead-area may be reduced, thus making it possible to enhance overall efficiency of the photoelectric module. More specifically, in the comparative example of FIG. 10, a first separation pattern P1', a second separation pattern P2', and a third separation pattern P3' are formed in different areas, and accordingly a width Wd' of a connecting area CA' is increased. However, in embodiments disclosed above, the second separation pattern P2 and the third separation pattern P3 are formed in the same area. Thus, the width Wd of the connecting area CA may be decreased, increasing the width remaining for the effective generation area GA, thereby improving efficiency of the photoelectric module in accordance with embodiments.

FIG. 11 is a schematic view illustrating a separation pattern of a photoelectric module according to the comparative example of FIG. 10. Referring to FIG. 11, in the photoelectric module, the first photoelectric cell C1' and the second photoelectric cell C2' are divided, and the first separation pattern P1', the second separation pattern P2', and the third separation pattern P3' may be formed to electrically connect the divided first and second photoelectric cells C1' and C2'.

Each of the first to third separation patterns P1', P2' and P3' is intended to divide a rear electrode 10, a light absorbing layer 15, and a front electrode 12 of the first and second photoelectric cells C1' and C2', and are formed in the shape of stripe patterns extending in a certain direction. The first to third separation patterns P1', P2' and P3' are spaced apart from one another by a sufficient margin in consideration of a process error, and therefore the connecting area CA' ranging from the first separation pattern P1' to the third pattern P3' has a relatively greater width Wd'.

When the configuration illustrated in FIG. 9 is compared with this comparative example, the connecting area CA ranging from the first separation pattern P1 to the third separation pattern P3 may have a relatively small width Wd by forming the bent pattern B2 of the second separation pattern P2 and the third separation pattern P3 in the same area. This means that an overall output power of the photoelectric module may be improved by limiting the connecting area CA, which may cause the output performance to be relatively deteriorated, to have a smaller width than the effective generation area GA.

Also, as illustrated in FIG. 9, since the first to third separation patterns P1, P2 and P3 have the bent patterns B1 and B2, the connecting portion T between the first separation pattern P1 and the second and third separation patterns P2 and P3 may be formed at an intermediate position and the stripe patterns L1 and L2 located where the connecting portion T is not formed may overlap, e.g., completely overlap, each other, so that the width Wd1 of the connecting area CA may be further reduced.

When the configuration illustrated in FIG. 9 is compared with the comparative example in FIG. 11, the effect of reducing the widths Wd and Wd1 of the connecting area CA may be estimated through a rough calculation as described below.

In the comparative example, the width Wd' of the total connecting area is 504 µm, assuming that the width of the first separation pattern P1' is 53 µm, the distance between the first and second separation patterns P1' and P2' is 162 µm, the width of the second separation pattern P2' is 73 µm, the distance between the second and third separation pattern P2' and P3' is 162 µm, and the width of the third separation pattern P3' is 54 µm. If the number of lines of the connecting area CA in the entire photoelectric module is 170 and the total length of the photoelectric module over which the connecting area CA extends is 154.9 cm, the area of the total connecting area CA' in the photoelectric module is 1327.18 cm², which corresponds to about 12% of 11,337 cm², i.e., the area of the entire photoelectric module.

In the configuration in FIG. 9, assuming that one side of a rectangular portion formed by the bent patterns B1 and B2 and the connecting portion T is 0.1219 cm and another side of thereof connection portion is 1 cm, the area of this rectangular portion is 0.1219 cm². Here, if the number of the connection portions T per one line of the connecting area CA is 26, the overall area of the rectangular portion is 3.1694 cm². If the widths of the stripe patterns L1 and L2, which overlap for the first to third separation patterns P1, P2, and P3, are 73 µm, and the total length of the photoelectric module over which the connecting area CA extends is 154.9 cm, the overall area of the stripe patterns L1 and L2 is 1.13077 cm². Accordingly, the overall area of the connecting area CA per one line of the connecting area CA is 4.30017 cm². If the number of lines of the entire connecting area CA is 170, the area of the total connecting area CA in the photoelectric module is 731.03 cm², which corresponds to about 6% of 11,337 cm², i.e., the area of the entire photoelectric module. From the comparison results of the embodiments and the comparative example, it can be appreciated that the area of the connecting area CA is reduced by about 45% relative to the connecting area CA'.

By way of summation and review, according to embodiments, in a module configuration where a plurality of photoelectric cells are connected in series or in parallel, the neighboring photoelectric cells are separated while the area of the connecting area for electrically connecting the separated photoelectric cells is minimized. In particular, in accordance with embodiments, a width of the connection area, which has a relatively low photoelectric conversion efficiency compared to the effective generation area, may be reduced or minimized. By thus minimizing the dead area, the area of the effective generation area with respect to the same substrate area can be relatively increased, and thus a photoelectric module with enhanced generation efficiency can be provided.

Example embodiments have been disclosed herein, and although specific terms are employed, they are used and are to be interpreted in a generic and descriptive sense only and not for purpose of limitation. As would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A photoelectric module comprising first and second photoelectric cells (C1, C2), wherein:
each of the first and second photoelectric cells comprises a rear electrode (111, 112), a light absorbing layer (151, 152) on the rear electrode and a front electrode (121, 122) on the light absorbing layer; and
the rear electrode (111) of the first photoelectric cell (C1) has a protruding portion (115) that forms a rear electrode connecting portion and the rear electrode (112) of the second photoelectric cell (C2) has a recessed portion arranged to receive the protruding portion (115); and
the front electrode of the second photoelectric cell has a protruding portion (125) that forms a front electrode connecting portion and the front electrode of the first photoelectric cell has a recessed portion arranged to receive the protruding portion (125),
wherein the rear and front electrode connecting portions (115, 125) are aligned to face one another and are electrically connected to each other.

2. The photoelectric module as claimed in claim 1, wherein the rear electrodes (111, 112) of the first and second photoelectric cells (C1, C2) are arranged on a common substrate (100).

3. The photoelectric module as claimed in any one of the preceding claims, wherein the rear electrode connecting portion (115) is integral with the rear electrode (111) of the first photoelectric cell.

4. The photoelectric module as claimed in any one of the preceding claims, wherein the front electrode connecting portion (125) is integral with the front electrode (122) of the second photoelectric cell.

5. The photoelectric module as claimed in any one of the preceding claims, wherein the rear electrode connecting portion (115) and the front electrode connecting portion (125) are electrically connected by the light absorbing layer of the first or the second photoelectric cell.

6. The photoelectric module as claimed in claim 5, wherein the light absorbing layer of the first or the second photoelectric cell includes a connecting portion (155) interposed between the rear electrode connecting portion (115) and the front electrode connecting portion (125).

7. The photoelectric module as claimed in claim 6, wherein the connecting portion comprises a protruding portion (155) of the light absorbing layer (151, 152) of the first or the second photoelectric cell.

8. The photoelectric module as claimed in claim 7, wherein the light absorbing layer (151, 152) of the other of the first and second photoelectric cells comprises a recessed portion arranged to receive the protruding portion (155).

9. The photoelectric module as claimed in any one of the preceding claims, wherein the rear and/or the front electrode connecting portions have angular or rounded corners.

10. The photoelectric module as claimed in any one of the preceding claims, wherein the respective rear electrodes of the first and second photoelectric cells are separated by a first separation pattern, the respective light absorption layers of the first and second photoelectric cells are separated by a second separation pattern and the respective front electrodes of the first and second photoelectric cells are separated by a third separation pattern, wherein the second and third separation patterns completely overlap, or wherein the first and second separation patterns completely overlap.

11. The photoelectric module as claimed in any one of the preceding claims, wherein the rear electrode connecting portion and the front electrode connecting portion completely overlap.

12. The photoelectric module as claimed in claim 11, when dependent on claim 7, wherein the rear electrode connecting portion and the front electrode connecting portion completely overlap with the protruding portion (155) of the light absorbing layer.

13. The photoelectric module as claimed in any one of the preceding claims, wherein the light absorbing layer comprises a chalcopyrite semiconductor.

14. The photoelectric module as claimed in claim 13, wherein the light absorbing layer comprises a CIGS (Copper-Indium-Gallium-Selenide)-based compound.
